# EUROPÄISCHE PATENTSCHRIFT

(11) **EP 3 565 012 B1**
(45) Veröffentlichungstag und Bekanntmachung des Hinweises auf die Patenterteilung: **07.06.2023**
(21) Anmeldenummer: 19169748.1
(22) Anmeldetag: 17.04.2019
(51) Int. Cl.: H01L 33/54

(54) **VERFAHREN ZUR HERSTELLUNG EINER LEUCHTE UND LEUCHTE DAZU**
METHOD FOR MANUFACTURING A LAMP AND LAMP FOR SAME
PROCÉDÉ DE FABRICATION D'UN LUMINAIRE ET LUMINAIRE CORRESPONDANT

(30) Priorität: 30.04.2018 DE 102018110389
(43) Veröffentlichungstag der Anmeldung: 06.11.2019
(73) Patentinhaber: FLASHAAR LEDLight GmbH & Co. KG, 55411 Bingen (DE)
(72) Erfinder: FLASHAAR-BLOEDORN, Swen, 55411 Bingen (DE); FITTING, Dan, 55288 Schornsheim (DE)
(74) Vertreter: Müller, Jochen

(56) Entgegenhaltungen:
- WO-A1-2015/001507
- DE-A1- 10 220 491
- DE-U1-202009 012 106
- DE-U1-202012 011 553
- IT-A1- UB20 160 015

## Beschreibung

Die Erfindung bezieht sich auf ein Verfahren zur Herstellung einer Leuchte mit einem Substrat auf dem mindestens ein Halbleiterchip zur Emission einer Lichtstrahlung angeordnet wird, und eine Leuchte dazu.

Die DE 10 2012 200 973 A1 offenbart eine Verfahren zur Herstellung einer Teilleuchte und eine Teilleuchte. Die Teilleuchte umfasst ein Substrat, dem mindestens ein Halbleiterchip zur Emission einer elektromagnetischen Strahlung zugeordnet ist. Ein elastischer Wellenleiter zur Durchmischung der elektromagnetischen Strahlung des Halbleiterchips ist dem Halbleiterchip in Abstrahlrichtung nachgeordnet. Damit der elastische Wellenleiter den mit Linsen bedeckten Halbleiterchip nachgeordnet werden kann, wird ein klarer Verguss aufgebracht. Der klare Verguss umgibt die Halbleiterchips und die Linsen vollständig. Beim Aushärten des klaren Vergusses bildet sich eine plane Oberfläche, an der beispielsweise durch einen Plasmaprozess der elastische Wellenleiter befestigt wird.

Die DE 10 2006 041 450 A1 beschreibt ein Gehäuse für LED-Leuchten, die in einer luftgefüllten optischen Kammer angeordnet sind, die ihrerseits vollständig mit Harz ummantelt ist. Zur Bildung der Kammer kann eine Haube aus klarem Material dienen, die einen U-förmigen Querschnitt aufweist.

Die WO 2015/001507 A1 beschreibt ein LED-Element, das auf einem Substrat in einem Gehäuse angeordnet ist. Das Gehäuse ist mit einem transparenten Kunststoff gefüllt, wobei zwischen dem Kunststoff und dem LED-Element ein Abstand besteht. Der Abstand ist durch eine transparente Schicht auf dem Kunststoff gewährleistet.

Die IT UB20 160 015 A1 zeigt eine Leuchte mit einem Substrat und einem LED-Chip. Über dem LED-Chip ist eine Abdeckung angeordnet, um einen Luftraum zwischen Abdeckung und LED-Chip zu bilden. Die Abdeckung wiederum ist von einem lichtdurchlässigen Kunstharz umgeben. Die Schenkel der Abdeckung stehen auf dem Substrat auf.

Der Verguss, beispielsweise mittels eines Polyurethan (PU) oder Silikonen, dient zum Schutz der Halbleiterchips und der zugeordneten Elektronik gegen eindringende Feuchtigkeit, die häufig Ursache für Kurzschlüsse bzw. Korrosion ist.

Eine LED weist in der Regel einen Aufbau aus einem monochromatischen Licht emittierenden Halbleiterchip auf, dessen Licht mit einem so genannten "Globe Top" in warm-, neutral- oder kalt-weißes Licht konvertiert wird. Diese Haube oder "Globe Top" besteht im Wesentlichen aus einem transparenten Epoxidharz oder Silikon mit eingebetteter Konversions-Leuchtschicht, die in nicht korrekter Weise auch "Phosphor" genannt wird. Die Zusammensetzung, Dichte und Gleichmäßigkeit dieser Haube bestimmen die Lichtfarbe, Farbtreue und Helligkeit der LED. Am einfachsten kann das "Globe Top" als Tropfen auf den "Die" genannten Halbleiterwürfel "getupft" werden. Dort härtet er aus und hüllt den Halbleiterchip komplett ein. Dies ist mit einem hohen fertigungstechnischen Aufwand verbunden, der wirtschaftlich und technisch nur in einer hochautomatisierten Produktionsanlage zu realisieren ist und die Fertigung von Leuchten in relativ hoher Lichtqualität und in relativ geringer Stückzahl nahezu unmöglich erscheinen lässt.

Stand der Technik stellen weiße Leuchtdioden (LED) mit einem ganz bestimmen Farbort dar, was bedeutet, dass LEDs, die in einem bestimmten Bereich auf dem planckschen Kurvenzug (X, Y Koordinaten) in den sogenannten MacAdams-Ellipsen mit in der Regel drei Schwelleneinheiten liegen, bzw. gebinnt (sortiert) sind, für das menschliche Auge gleich aussehen. Insbesondere in der Architektur ist es sehr wichtig, dass alle in einer Linie angeordneten LEDs den gleichen Farbort, also die gleiche Qualität, aufweisen, zum Beispiel 2700 Kelvin für Warmweiß. Dementsprechend sind beispielsweise Leuchten reproduzierbar mit 2700° Kelvin in der Schutzart IP40, beispielsweise für Anwendungen im Innenbereich, reproduzierbar zu fertigen.

Für Leuchten mit höheren Schutzarten, beispielsweise IP 63, IP 65, IP 67, IP 69 werden LEDs mittels beispielswiese transparentem oder eingefärbtem, z.B. weißem Polyurethan oder Silikon übergossen, das anschließend aushärtet, wodurch der Brechungsindex verändert wird, und zwar derart, dass beispielsweise aus 2700°K ca. 3500°K, aus 4000°K ca. 8000°K werden, usw. Eine Vorhersage wohin der Farbort durch die verwendete Vergussmasse driftet ist nicht oder nur sehr schwer möglich, so dass Leuchten mit unterschiedlichen Schutzarten und gleichen Farborten, die einen gemeinsamen grundsätzlichen Aufbau, also gleiches Substrat, gleiche Halbleiterchips und dergleichen aufweisen, nicht herstellbar bzw. lieferbar sind.

Der Erfindung liegt die Aufgabe zugrunde, ein Verfahren und eine Leuchte der eingangs genannten Art zu schaffen, das bzw. die bei unterschiedlichen Schutzarten, also insbesondere bei einer Verwendung sowohl im Inneren eines Gebäudes als auch Außen, den selben Farbort aufweist und dabei auch in relativ geringen Umfang mit einem verhältnismäßig geringen technischen Aufwand, insbesondere ohne den Einsatz von Robotertechnik, herstellbar ist.

Erfindungsgemäß wird die Aufgabe durch die Merkmale der unabhängigen Ansprüche gelöst.

Die Unteransprüche stellen vorteilhafte Ausgestaltungen der Erfindung dar.

Bei einem Verfahren zur Herstellung einer Leuchte mit einem Substrat, auf dem mindestens ein Halbleiterchip zur Emission einer Lichtstrahlung angeordnet wird, wird dem Substrat eine den mindestens einen Halbleiterchip überdeckende Abdeckung abgedichtet zugeordnet.

Bei einer Leuchte, die ein Substrat umfasst, auf dem mindestens ein Halbleiterchip zur Emission einer Lichtstrahlung angeordnet ist, ist dem Substrat eine den mindestens einen Halbleiterchip abgedichtet überdeckende Abdeckung zugeordnet, wobei Schenkel der Abdeckung klemmend an dem Substrat anliegen und ein die Schenkel verbindender Steg beabstandet zu dem Substrat verläuft, so dass ein Luftraum zwischen dem Substrat und dem Inneren der Abdeckung vorliegt, in dem die Halbleiterchips beabstandet zu der Abdeckung angeordnet sind, und die Abdeckung außenseitig vollständig mit einer lichtstrahlungsdurchlässigen Kunststoffmasse ummantelt wird.

Zudem besteht zwischen der Abdeckung und dem Halbleiterchip bzw. dem mit dem Halbleiterchip bestückten Substrat ein Luftraum, der keine Änderung des Brechungsindex gegenüber einer Leuchte ohne Abdeckung bewirkt. Dementsprechend ist der Farbort der Leuchte mit der Abdeckung im dem Farbort der Leuchte ohne Abdeckung, selbstverständlich mit jeweils gleichen Halbleiterchips, also LEDs, identisch.

Bei dem Substrat handelt es sich insbesondere um eine Aluminiumkernplatine oder eine so genannte FR4-Platine, auf die die transparente Abdeckung aufgeschoben und sauber eingedichtet wird. Aufgrund der Abdichtung ist eine höhere Schutzklasse gegenüber einer Leuchte ohne eine abgedichtete Abdeckung erzielt. Mit FR4 wird eine Klasse von schwer entflammbaren und flammenhemmenden Verbundwerkstoffen bestehend aus Epoxidharz und Glasfasergewebe bezeichnet. FR4 wird unter anderem als elektrisch nichtleitendes Trägermaterial bei elektrischen Leiterplatten eingesetzt.

Selbstverständlich ist die Geometrie der Abdeckung an das Substrat angepasst. Weist die Leuchte einen länglichen, stabförmigen Verlauf auf, sind auch das Substrat und die Abdeckung länglich und stabförmig ausgebildet. Im Weiteren kann die Abdeckung formschlüssig oder kraftschlüssig mit dem Substrat verbunden werden, beispielsweise mittels Pressverbindungen oder Klipsverbindungen oder Nuten und Federn, die ineinander schiebbar sind. Die Abdeckung kann auch klemmend auf das Substrat aufgesetzt werden.

Zweckmäßigerweise wird die Abdeckung zu dem Halbleiterchip beabstandet angeordnet. Durch den Abstand zwischen der Abdeckung und dem Halbleiterchip ist der Luftraum variierbar.

Zur Bereitstellung einer spritzwassergeschützten oder wasserdichten Leuchte wird die Abdeckung außenseitig vollständig mit einer lichtstrahlungsdurchlässigen Kunststoffmasse ummantelt. Der Fachmann spricht auch von einem Vergie-βen, mit dem eine Erhöhung der Schutzklasse einhergeht, basierend auf dem Verkapslungseffekt. Die lichtstrahlungsdurchlässige Kunststoffmasse, mit der die Abdeckung an sämtlichen Außenseiten umgossen ist, ist also transluzent. Selbstverständlich kann die Kunststoffmasse auch transparent ausgeführt und insbesondere beliebig eingefärbt sein.

In Ausgestaltung umfasst die Abdeckung einen Steg, an den sich zwei parallel und beabstandet zueinander ausgerichtete Schenkel anschließen, wobei die freien Schenkel das Substrat zwischen sich aufnehmen oder auf dem Substrat aufstehen. Die Abdeckung weist demnach insbesondere einen im Wesentlichen U-förmigen Querschnitt auf und ist in Ihrer Breite an das Substrat, die die LEDs aufweisende Platine, angepasst. Die Abdeckung lässt sich beispielsweise als Stabmaterial fertigen, insbesondere durch Extrudieren, und an die Länge des Substrats bzw. der Leuchte anpassen. Zur Halterung der Abdeckung kann das Substrat unter Vorspannung zwischen den freien Enden der Schenkel der Abdeckung eingeschoben werden. Es ist auch möglich, beispielsweise die Abdeckung mit Nasen, also Hintergriffen, im Bereich der freien Enden der Schenkel zu fertigen, die das Substrat entweder unterseitig untergreifen oder in Nuten des Substrats eingreifen. Ebenso kann die Abdeckung im Bereich der freien Enden der Schenkel Nuten aufweisen, in die das Substrat einschiebbar ist.

Im Rahmen der Erfindung kann die Formgebung der Abdeckung an sich beliebig gewählt werden, beispielsweise konkav oder konvex ausgebildet sein, um Licht zu streuen oder zu bündeln, oder einen im Wesentlichen U-förmigen Querschnitt aufweisen, je nach den gewünschten Eigenschaften. Dabei ist die Abdeckung stets so ausgebildet, dass zwischen dem Substrat beziehungsweise dem Licht emittierenden Halbleiterchip stets ein ausreichender Luftraum gebildet ist, um durch das anschließende Vergießen der Abdeckung beispielsweise mit Polyurethan die erhaltene Farbtemperatur der Leuchte nicht zu verändern.

Nach einer Weiterbildung sind das Substrat und die Abdeckung in einem U-förmigen Leuchtengehäuse angeordnet, wobei das Substrat auf einem Leuchtengehäusesteg befestigt ist. Das Leuchtengehäuse kann aus einem extrudierten Stabmaterial gefertigt sein und Nuten zur Halterung des Substrats aufweisen.

Vorzugsweise ist die Abdeckung aus einem transparenten thermoplastischen Kunststoff gefertigt. Besonders bevorzugt ist der Kunststoff ein Polycarbonat (PC) und/oder ein Polymethylmethacrylat (PMMA).

Zur Bereitstellung einer Leuchte mit besonderen Eigenschaften, beispielsweise zur Verwendung in einem Außenbereich, ist der Freiraum zwischen der Abdeckung und dem Leuchtengehäuse mit der lichtstrahlungsdurchlässigen, also transluzenten oder auch transparenten Kunststoffmasse, die selbstverständlich auch beliebig eingefärbt sein kann, gefüllt. Bevorzugt ist die Abdeckung mit einem transluzenten Polyurethan oder einem transluzenten Silikon übergossen. Besonders bevorzugt ist das Leuchtengehäuse komplett mit der Kunststoffmasse gefüllt. Sonach kann eine Leuchte beispielsweise mit der Schutzart IP63, IP65, IP67 oder IP69 bereitgestellt werden.

Bevorzugt sind an der Abdeckung und/oder dem Substrat jeweils Rastvorsprünge und/oder Rastvertiefungen zur Bildung einer insbesondere form- und kraftschlüssigen Rastverbindung zwischen Abdeckung und Substrat zusammenwirken. Durch diese Rastverbindung kann die Abdeckung entweder auf das Substrat aufgeclipst werden oder das Substrat wird in die Abdeckung eingeschoben. Die Rastverbindung kann ebenso Hintergriffe, Hinterschnitte und dergleichen umfassen. Es versteht sich, dass eine beispielsweise U-förmige Abdeckung derart ausgebildet ist, dass die seitlich von einem Steg abragenden Schenkel eine ausreichende Klemmkraft der Rastverbindung an dem Substrat aufbringen, um ein unbeabsichtigtes Lösen zu vermeiden.

Um ein Eindringen der Kunststoffmasse beim Vergießen der Leuchte in den Luftraum zwischen Abdeckung und Substrat zu vermeiden kann der Abdeckung beziehungsweise dem Substrat eine Dichtung zugeordnet sein. Diese dichtet im montierten Zustand beispielsweise die Rastverbindung zusätzlich ab. Als Material für diese Dichtung können in Abhängigkeit der Materialien der Abdeckung, des Substrats und der Kunststoffmasse ebenfalls unterschiedliche Kunststoffe gewählt werden. Beispielsweise ist die Dichtung an der Abdeckung angeordnet und liegt dann im verrasteten Zustand derart an der Abdeckung an, dass keine Kunststoffmasse oder Feuchtigkeit in den Luftraum eindringen kann.

Weiterhin ist vorgeschlagen, dass das Substrat seinerseits auf einem Einschubprofil, beispielsweise ebenfalls aus Kunststoff, angeordnet ist. Dieses Einschubprofil kann dann zum Beispiel mit der bereits aufgeclipsten Abdeckung in ein vorzugsweise U-förmiges Leuchtengehäuse eingeschoben werden, wobei die Formgebungen von Einschubprofil und Leuchtengehäuse zueinander korrespondieren. Dies erleichtert den Montageaufwand.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der Erfindung ist nur durch die Ansprüche definiert.

Die Erfindung wird im Folgenden anhand eines Ausführungsbeispiels unter Bezugnahme auf die zugehörige Zeichnung näher erläutert. Es zeigen:
- Fig. 1: einen Querschnitt durch eine Leuchte und
- Fig. 2: einen weiteren Querschnitt nach der Erfindung.

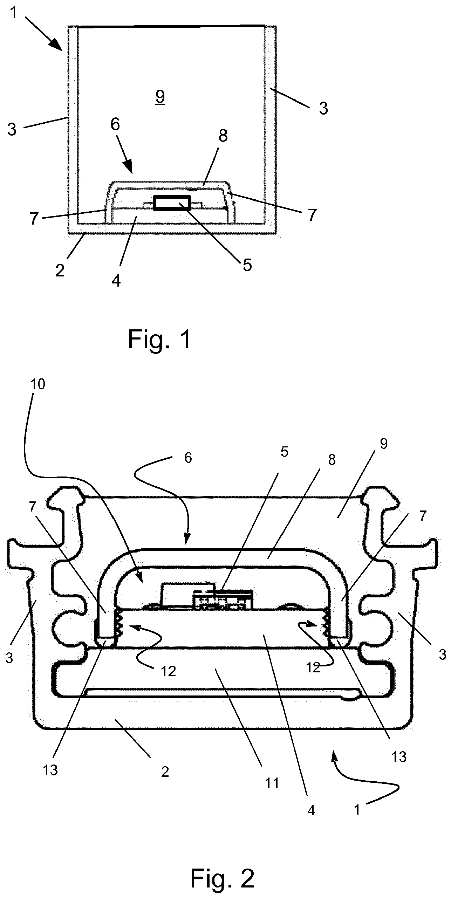

Die Leuchte umfasst wie aus Fig. 1 ersichtlich ein im Querschnitt im Wesentlichen U-förmiges Leuchtengehäuse 1 mit einem Leuchtengehäusesteg 2, von dem zwei parallel zueinander ausgerichtete Leuchtengehäuseschenkel 3 abgehen. Die vorliegende Leuchte ist im Wesentlichen stabförmig, weist also eine Längserstreckung auf. Es ist aber für den Fachmann ersichtlich, dass die Leuchte auch eine beliebige andere Geometrie aufweisen kann, beispielsweise rund gefertigt ist. Auf dem Leuchtengehäusesteg 2 ist beabstandet zwischen den Leuchtengehäuseschenkeln 3 ein Substrat 4, beispielsweise in Form einer Aluminiumkernplatine, angeordnet, das Lichtstrahlung emittierende Halbleiterchips 5, so genannte LEDs, trägt, von denen eine Vielzahl vorgesehen ist und die den gleichen Farbort aufweisen.

Um eine Leuchte mit einer gegenüber der ungeschützten Schutzart erhöhten Schutzart bereitzustellen, die den gleichen Farbort wie die LEDs der Leuchte mit der niedrigen Schutzart aufweist, wird auf das Substrat 4 eine im Wesentlichen U-förmige Abdeckung 6 aufgesetzt und zwar derart, dass die Schenkel 7 der Abdeckung 6 klemmend an dem Substrat 4 anliegen und der die Schenkel 7 verbindende Steg 8 beabstandet zu dem Substrat 4 verläuft, so dass ein Luftraum 10 zwischen dem Substrat 4 und dem Inneren der Abdeckung 6 vorliegt, in dem die Halbleiterchips 5 angeordnet sind. Die Abdeckung 6 wird gegenüber dem Substrat 4 abgedichtet. Die Abdeckung 6 ist aus einem transluzenten Kunststoff, insbesondere einem PC und/oder PMMA gefertigt oder einer Mischung verschiedener transluzenter Kunststoffe und kann auch beliebig eingefärbt sein. Prinzipiell kann die Abdeckung 6 auch andere Formgebungen aufweisen beispielsweise konkav oder konvex, so lange ein ausreichender Luftraum 10 zwischen Abdeckung 6 und Halbleiterchip 5 vorhanden ist, um die Farbtemperatur trotz einer Kunststoffmasse 9 nicht zu verändern.

Das Leuchtengehäuse 1 wird mit einer lichtstrahlungsdurchlässigen Kunststoffmasse 9, die also transluzent ist, insbesondere auch transparent und/oder eingefärbt sein kann, derart gefüllt, dass die Abdeckung 6 von diesem Vergusswerkstoff nach der Aushärtung außenseitig vollständig ummantelt ist. Die Kunststoffmasse 9, insbesondere ein transluzentes Polyurethan, wird bis zur freien Oberkante der Leuchtengehäuseschenkel 3 in das Leuchtengehäuse 1 gefüllt. Selbstverständlich wird die Abdeckung 6 auch stirnseitig abgedichtet verschlossen. Das Polyurethan kann auch beispielsweise weiß eingefärbt sein.

In Fig. 2 ist eine weitere Leuchte dargestellt. Sie umfasst wie in Fig. 1 ein im Wesentlichen U-förmiges Leuchtengehäuse 1 mit einem Leuchtengehäusesteg 2 und zwei davon abragenden Leuchtengehäuseschenkeln 3. Prinzipiell sind auch andere Formgebungen denkbar. Ein Substrat 4 ist auf einem Einschubprofil 11 beispielsweise aus Kunststoff angeordnet. Dabei sind das Einschubprofil 11 und das Leuchtengehäuse 1 derart korrespondierend geformt, dass sie senkrecht zur Zeichenebene ineinandergeschoben werden können. Die Abdeckung 6 mit dem Steg 8 und den Schenkeln 7 ist auf das Substrat 4 aufgeclipst oder ebenfalls senkrecht zur Zeichenebene ineinandergeschoben. Insbesondere wird durch die Schenkel 7 eine Klemmkraft auf das Substrat 4 ausgeübt. Hierzu dient eine hier schematisch dargestellte Rastverbindung 12 mit zueinander korrespondierenden Rastvorsprüngen, Rastvertiefungen, Hinterschnitten, Hintergriffen und dergleichen an Abdeckung 6 und/oder Substrat 4. Zusammen mit einer Dichtung 13 beispielsweise aus einem elastischen Kunststoffmaterial wird der Luftraum 10 zwischen Abdeckung 6 und Halbleiterchip 5 beziehungsweise Substrat 4 gegen das Eindringen der Kunststoffmasse 9 zuverlässig abgedichtet. Dabei kann der Luftraum 10 beziehungsweise die Abdeckung 6 eine an sich beliebige Formgebung aufweisen, bevorzugt wie hier dargestellt aber U-förmig. Beispielsweise beträgt der Abstand zwischen Steg 8 und Substrat 4 einige Millimeter.

### Bezugszeichen

- 1.: Leuchtengehäuse
- 2.: Leuchtengehäusesteg
- 3.: Leuchtengehäuseschenkel
- 4.: Substrat
- 5.: Halbleiterchip
- 6.: Abdeckung
- 7.: Schenkel
- 8.: Steg
- 9.: Kunststoffmasse
- 10.: Einschubprofil
- 11.: Luftraum
- 12.: Rastverbindung
- 13.: Dichtung

## Patentansprüche

1. Verfahren zur Herstellung einer Leuchte mit einem Substrat (4) auf dem mindestens ein Halbleiterchip (5) zur Emission einer Lichtstrahlung angeordnet wird, wobei dem Substrat (4) eine den mindestens einen Halbleiterchip (5) überdeckende Abdeckung (6) abgedichtet zugeordnet wird und ein die Schenkel (7) verbindender Steg (8) beabstandet zu dem Substrat (4) verläuft, so dass ein Luftraum (10) zwischen dem Substrat (4) und dem Inneren der Abdeckung (6) vorliegt, in dem die Halbleiterchips (5) beabstandet zu der Abdeckung (6) angeordnet sind, und die Abdeckung (6) außenseitig vollständig mit einer lichtstrahlungsdurchlässigen Kunststoffmasse (9) ummantelt wird, **dadurch gekennzeichnet, dass** Schenkel (7) der Abdeckung (6) klemmend an dem Substrat (4) anliegen.

2. Leuchte umfassend ein Substrat (4), auf dem mindestens ein Halbleiterchip (5) zur Emission einer Lichtstrahlung angeordnet ist, wobei dem Substrat (4) eine den mindestens einen Halbleiterchip (5) überdeckende Abdeckung (6) abgedichtet zugeordnet ist und ein die Schenkel (7) verbindender Steg (8) beabstandet zu dem Substrat (4) verläuft, so dass ein Luftraum (10) zwischen dem Substrat (4) und dem Inneren der Abdeckung (6) vorliegt, in dem die Halbleiterchips (5) beabstandet zu der Abdeckung (6) angeordnet sind, und die Abdeckung (6) außenseitig vollständig mit einer lichtstrahlungsdurchlässigen Kunststoffmasse (9) ummantelt ist, **dadurch gekennzeichnet, dass** Schenkel (7) der Abdeckung (6) klemmend an dem Substrat (4) anliegen.

3. Leuchte nach Anspruch 2, **dadurch gekennzeichnet, dass** die Abdeckung (6) einen Steg (8) umfasst, an den sich zwei parallel und beabstandet zueinander ausgerichtete Schenkel (7) anschließen, wobei die freien Schenkel (7) das Substrat (4) zwischen sich aufnehmen.

4. Leuchte nach Anspruch 3, **dadurch gekennzeichnet, dass** die Abdeckung (6) im Querschnitt U-förmig oder trapezförmig oder bogenförmig ausgebildet ist.

5. Leuchte nach Anspruch 3, **dadurch gekennzeichnet, dass** der Steg (8) geradlinig ausgebildet und parallel zu einer die Halbleiterchips (5) aufweisenden Oberfläche des Substrats (4) ausgerichtet ist.

6. Leuchte nach einem der Ansprüche 2 bis 5, **dadurch gekennzeichnet, dass** das Substrat (4) und die Abdeckung (6) in einem U-förmigen Leuchtengehäuse (1) angeordnet sind, wobei das Substrat (4) auf einem Leuchtengehäusesteg (2) befestigt ist.

7. Leuchte nach einem der Ansprüche 2 bis 6, **dadurch gekennzeichnet, dass** die Abdeckung (6) aus einem transparenten thermoplastischen Kunststoff gefertigt ist.

8. Leuchte nach Anspruch 7, **dadurch gekennzeichnet, dass** der Kunststoff ein Polymethylmethacrylat und/oder ein Polycarbonat ist.

9. Leuchte nach einem der Ansprüche 2 bis 8, **dadurch gekennzeichnet, dass** der Freiraum zwischen der Abdeckung (6) und dem Leuchtengehäuse (1) mit einer lichtstrahlungsdurchlässigen Kunststoffmasse (9) gefüllt ist.

10. Leuchte nach einem der Ansprüche 2 bis 9, **dadurch gekennzeichnet, dass** die Abdeckung (6) mit einem transluzenten Polyurethan oder einem transluzenten Silikon übergossen ist.

11. Leuchte nach einem der Ansprüche 2 bis 10, **dadurch gekennzeichnet, dass** das Leuchtengehäuse (1) komplett mit der Kunststoffmasse (9) gefüllt ist.

12. Leuchte nach einem der Ansprüche 2 bis 11, **dadurch gekennzeichnet, dass** zwischen der Abdeckung (6) und dem Substrat (4) eine Rastverbindung (12) besteht.

13. Leuchte nach einem der Ansprüche 2 bis 12, **dadurch gekennzeichnet, dass** der Abdeckung (6) und dem Substrat (4) eine Dichtung (13) zugeordnet ist.

14. Leuchte nach einem der Ansprüche 2 bis 10, **dadurch gekennzeichnet, dass** das Substrat (4) auf einem Einschubprofil (11) angeordnet ist.

15. Leuchte nach einem der Ansprüche 2 bis 14, **gekennzeichnet durch** eine geradlinige Längserstreckung in ihrer Haupterstreckungsrichtung.

## Claims

1. Method for producing a lamp having a substrate (4) on which at least one semiconductor chip (5) for emitting light radiation is arranged, a cover (6) covering the at least one semiconductor chip (5) being sealingly associated with the substrate (4) and a bridge (8) connecting the legs (7) extending at a distance from the substrate (4) so that an air space (10) is present between the substrate (4) and the interior of the cover (6), in which air space the semiconductor chips (5) are arranged at a distance from the cover (6), and the cover (6) being completely encased on its outer side by a plastics mass (9) permeable to light radiation, **characterized in that** legs (7) of the cover (6) bear against the substrate (4) in a clamping manner.

2. Lamp comprising a substrate (4) on which at least one semiconductor chip (5) for emitting light radiation is arranged, a cover (6) covering the at least one semiconductor chip (5) being sealingly associated with the substrate (4), and a bridge (8) connecting the legs (7) extending at a distance from the substrate (4) so that an air space (10) is present between the substrate (4) and the interior of the cover (6), in which air space the semiconductor chips (5) are arranged at a distance from the cover (6), and the cover (6) being completely encased on its outer side by a plastics mass (9) permeable to light radiation, **characterized in that** legs (7) of the cover (6) bear against the substrate (4) in a clamping manner.

3. Lamp according to claim 2, **characterized in that** the cover (6) comprises a bridge (8) adjoined by two parallel, mutually spaced legs (7), the free legs (7) receiving the substrate (4) between them.

4. Lamp according to claim 3, **characterized in that** the cover (6) is designed to have a U-shaped, trapezoidal or curved cross-section.

5. Lamp according to claim 3, **characterized in that** the bridge (8) is rectilinear and is oriented so as to be parallel to a surface of the substrate (4) that comprises the semiconductor chips (5).

6. Lamp according to any of claims 2 to 5, **characterized in that** the substrate (4) and the cover (6) are arranged in a U-shaped lamp housing (1), the substrate (4) being fastened to a lamp housing bridge (2).

7. Lamp according to any of claims 2 to 6, **characterized in that** the cover (6) is made from a transparent thermoplastic material.

8. Lamp according to claim 7, **characterized in that** the plastic is a polymethyl methacrylate and/or a polycarbonate.

9. Lamp according to any of claims 2 to 8, **characterized in that** the free space between the cover (6) and the lamp housing (1) is filled with a plastics mass (9) permeable to light radiation.

10. Lamp according to any of claims 2 to 9, **characterized in that** the cover (6) is overmolded with a translucent polyurethane or a translucent silicone.

11. Lamp according to any of claims 2 to 10, **characterized in that** the lamp housing (1) is completely filled with the plastics mass (9).

12. Lamp according to any of claims 2 to 11, **characterized in that** there is a latching connection (12) between the cover (6) and the substrate (4).

13. Lamp according to any of claims 2 to 12, **characterized in that** a seal (13) is associated with the cover (6) and with the substrate (4).

14. Lamp according to any of claims 2 to 10, **characterized in that** the substrate (4) is arranged on an insertion profile (11).

15. Lamp according to any of claims 2 to 14, **characterized by** a rectilinear longitudinal extension in its main extension direction.

## Revendications

1. Procédé de fabrication d'un luminaire comportant un substrat (4) sur lequel est disposée au moins une puce semi-conductrice (5) pour l'émission d'un rayon lumineux, dans lequel un élément de recouvrement (6) recouvrant l'au moins une puce semi-conductrice (5) est associé de manière étanche au substrat (4), et une traverse (8) reliant les branches (7) s'étend à distance du substrat (4), de sorte qu'un espace d'air (10) est présent entre le substrat (4) et l'intérieur de l'élément de recouvrement (6), dans lequel espace d'air les puces semi-conductrices (5) sont disposées à distance de l'élément de recouvrement (6), et que l'élément de recouvrement (6) est complètement enveloppé à l'extérieur d'une matière synthétique (9) perméable aux rayons lumineux, **caractérisé en ce que** les branches (7) de l'élément de recouvrement (6) reposent par serrage sur le substrat (4).

2. Luminaire comprenant un substrat (4) sur lequel est disposée au moins une puce semi-conductrice (5) pour l'émission d'un rayon lumineux, dans lequel un élément de recouvrement (6) recouvrant l'au moins une puce semi-conductrice (5) est associé de manière étanche au substrat (4), et une traverse (8) reliant les branches (7) s'étend à distance du substrat (4), de sorte qu'un espace d'air (10) est présent entre le substrat (4) et l'intérieur de l'élément de recouvrement (6), dans lequel espace d'air les puces semi-conductrices (5) sont disposées à distance de l'élément de recouvrement (6), et que l'élément de recouvrement (6) est complètement enveloppé à l'extérieur d'une matière synthétique (9) perméable aux rayons lumineux, **caractérisé en ce que** les branches (7) de l'élément de recouvrement (6) reposent par serrage sur le substrat (4).

3. Luminaire selon la revendication 2, **caractérisé en ce que** l'élément de recouvrement (6) comprend une traverse (8) à laquelle les deux branches (7) alignées parallèlement et à distance l'une de l'autre se raccordent, les branches (7) libres recevant le substrat (4) entre elles.

4. Luminaire selon la revendication 3, **caractérisé en ce que** l'élément de recouvrement (6) est réalisé en forme de U ou en forme trapézoïdale ou en forme d'arc en section transversale.

5. Luminaire selon la revendication 3, **caractérisé en ce que** la traverse (8) est réalisée de manière rectiligne et alignée parallèlement à une surface du substrat (4) présentant les puces semi-conductrices (5).

6. Luminaire selon l'une des revendications 2 à 5, **caractérisé en ce que** le substrat (4) et l'élément de recouvrement (6) sont disposés dans un boîtier de luminaire (1) en forme de U, le substrat (4) étant fixé sur une traverse de boîtier de luminaire (2).

7. Luminaire selon l'une des revendications 2 à 6, **caractérisé en ce que** l'élément de recouvrement (6) est fabriqué à partir d'une matière synthétique thermoplastique transparente.

8. Luminaire selon la revendication 7, **caractérisé en ce que** la matière synthétique est un polyméthacrylate de méthyle et/ou un polycarbonate.

9. Luminaire selon l'une des revendications 2 à 8, **caractérisé en ce que** l'espace libre entre l'élément de recouvrement (6) et le boîtier de luminaire (1) est rempli d'une matière synthétique (9) perméable aux rayons lumineux.

10. Luminaire selon l'une des revendications 2 à 9, **caractérisé en ce que** l'élément de recouvrement (6) est surmoulé d'un polyuréthane translucide ou d'un silicone translucide.

11. Luminaire selon l'une des revendications 2 à 10, **caractérisé en ce que** le boîtier de luminaire (1) est entièrement rempli de la matière synthétique (9).

12. Luminaire selon l'une des revendications 2 à 11, **caractérisé en ce qu'**il existe une liaison par encliquetage (12) entre l'élément de recouvrement (6) et le substrat (4).

13. Luminaire selon l'une des revendications 2 à 12, **caractérisé en ce qu'**un joint d'étanchéité (13) est associé à l'élément de recouvrement (6) et au substrat (4).

14. Luminaire selon l'une des revendications 2 à 10, **caractérisé en ce que** le substrat (4) est disposé sur un profilé d'insertion (11).

15. Luminaire selon l'une des revendications 2 à 14, **caractérisé par** une extension longitudinale rectiligne dans sa direction d'extension principale.
